# EUROPÄISCHE PATENTSCHRIFT

(11) **EP 2 865 022 B1**
(45) Veröffentlichungstag und Bekanntmachung des Hinweises auf die Patenterteilung: **17.08.2016**
(21) Anmeldenummer: 13737556.4
(22) Anmeldetag: 21.06.2013
(51) Int. Cl.: H01L 35/30

(54) **THERMOELEKTRISCHES MODUL MIT WÄRMETAUSCHER**
THERMOELECTRIC MODULE WITH HEAT EXCHANGER
MODULE THERMOÉLECTRIQUE AVEC ÉCHANGEUR DE CHALEUR

(30) Priorität: 22.06.2012 DE 102012210565
(43) Veröffentlichungstag der Anmeldung: 29.04.2015
(73) Patentinhaber: Eberspächer Exhaust Technology GmbH & Co. KG, 66539 Neunkirchen (DE)
(72) Erfinder: OESTERLE, Jörg, 89150 Laichingen (DE); RESCH, Andreas, 71032 Böblingen (DE); LEICHT, Sebastian, 72406 Bisingen (DE); SPIETH, Arnulf, 73269 Hochdorf (DE); TCHAMGOUE, Herve, 73730 Esslingen (DE); MOHR, Ralf, 69118 Heidelberg (DE)
(74) Vertreter: BRP Renaud & Partner mbB Rechtsanwälte Patentanwälte Steuerberater
(86) Internationale Anmeldenummer: PCT/EP2013/063023
(87) Internationale Veröffentlichungsnummer: WO 2013/190105

(56) Entgegenhaltungen:
- EP-A2- 1 203 923
- EP-A2- 2 337 101
- EP-A2- 2 378 578
- EP-A2- 2 383 533

## Beschreibung

Die vorliegende Erfindung betrifft einen Wärmetauscher, insbesondere für eine Abgasanlage einer Brennkraftmaschine, vorzugsweise in einem Kraftfahrzeug, mit den Merkmalen des Oberbegriffs des Anspruchs 1. Die vorliegende Erfindung betrifft außerdem eine mit einem derartigen Wärmetauscher ausgestattete Brennkraftmaschine.

Ein derartiger Wärmetauscher ist z.B. aus der EP 2 337 101 A2 bekannt.

Um bei Brennkraftmaschinen, insbesondere bei Fahrzeuganwendungen, den energetischen Wirkungsgrad zu verbessern, bestehen Bestrebungen, Wärmeenergie, die im Abgas der Brennkraftmaschine enthalten ist, zu nutzen. Eine Möglichkeit zur Nutzung der im Abgas enthaltenen Wärmeenergie ist dabei die Verwendung so genannter thermoelektrischer Module, die eine Temperaturdifferenz in eine elektrische Spannung bzw. einen Wärmestrom in einen elektrischen Strom wandeln können. Derartige thermoelektrische Module arbeiten dabei nach dem so genannten Seebeck-Effekt, der einer Invertierung des so genannten Peltier-Effekts entspricht.

Ein thermoelektrisches Modul weist eine Heißseite und eine Kaltseite auf und kann im Betrieb thermische Energie, also Wärme in elektrische Energie wandeln. Durch Zuführen von Wärme zur Heißseite und durch Abführen von Wärme an der Kaltseite kann ein Wärmestrom durch das jeweilige thermoelektrische Modul hindurchgeführt werden, der im thermoelektrischen Modul in einen elektrischen Strom gewandelt wird. Um die Heißseite mit Wärme und die Kaltseite mit Kälte versorgen zu können, kann ein thermoelektrisches Modul zweckmäßig in einen Wärmetauscher integriert sein, der zumindest ein Heizrohr zum Führen eines Heizfluids und wenigstens ein Kühlrohr zum Führen eines Kühlfluids aufweist.

Das thermoelektrische Modul ist dann zwischen einem solchen Heizrohr und einem solchen Kühlrohr so angeordnet, dass sich das Heizrohr an der Heißseite des jeweiligen thermoelektrischen Moduls und das Kühlrohr an der Kaltseite des jeweiligen thermoelektrischen Moduls befindet. Zu diesem Zweck sind das Heizrohr, das thermoelektrische Modul und das Kühlrohr in einer Stapelrichtung aufeinander gestapelt und bilden so einen Stapel.

Bei derartigen Wärmetauschern, in die wenigstens ein thermoelektrisches Modul integriert ist, hat sich gezeigt, dass die Wärmeübertragung zwischen den Rohren und dem jeweiligen thermoelektrischen Modul signifikant verbessert werden kann, wenn der Stapel in der Stapelrichtung vorgespannt ist. Durch die Vorspannung kommt es zwischen den für eine Kontaktierung vorgesehenen Kontaktflächen zu einer flächigen Kontaktierung, die eine weitgehend homogene Wärmeübertragung über die jeweilige Kontaktfläche ermöglicht. Problematisch ist dabei, dass die Heizrohre und die Kühlrohre zweckmäßig mit vergleichsweise geringen Wandstärken hergestellt werden, um den Wärmetransport durch die Rohrwände zu verbessern. Hierdurch ist jedoch die Druckfestigkeit der Rohre reduziert. Um dennoch die erwünschte Vorspannung im Stapel realisieren zu können, sind grundsätzlich unterschiedliche Ansätze möglich. Beispielsweise können in die Rohre Stützstrukturen eingebracht werden, welche die Rohre von innen aussteifen. Zusätzlich oder alternativ ist es möglich, die Rohre an ihrer dem jeweiligen thermoelektrischen Modul zugewandten Rohraußenseite zum thermoelektrischen Modul hin konkav zu wölben, wobei diese gewölbte Außenseite beim Verspannen des Stapels mit einer dem jeweiligen Rohr zugewandten ebenen Modulaußenseite verpresst wird, wodurch die gewölbte Rohraußenseite eingeebnet wird und flächig an der ebenen Modulaußenseite zur Anlage kommt.

Desweiteren besteht bei einer überhöhten Vorspannung grundsätzlich die Gefahr, dass die Rohraußenseite beult und sich dadurch zum jeweiligen thermoelektrischen Modul hin konkav wölbt, wodurch die Kontaktierung weitgehend aufgehoben ist. Auch in diesem Fall können wieder Stützstrukturen im jeweiligen Rohr angeordnet werden, um ein derartiges Beulen des jeweiligen Rohrs zu vermeiden. Das Einsetzen von Stützstrukturen ist jedoch mit einem vergleichsweise hohen Aufwand verbunden. Außerdem sind hier recht enge Toleranzen einzuhalten, damit die Stützstrukturen die gewünschte Geometrie des jeweiligen Rohrs gewährleisten können.

Die vorliegende Erfindung beschäftigt sich mit dem Problem, für einen Wärmetauscher der eingangs genannten Art bzw. für eine damit ausgestattete Brennkraftmaschine eine verbesserte Ausführungsform anzugeben, die sich insbesondere dadurch auszeichnet, dass mit einer vergleichsweise hohen Zuverlässigkeit ein relativ hoher Wärmeübergang zwischen dem jeweiligen thermoelektrischen Modul und dem jeweiligen Rohr realisierbar ist.

Dieses Problem wird erfindungsgemäß durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, zumindest eine Modulaußenseite, die in der Stapelrichtung einem der Rohre zugewandt ist, zum jeweiligen Rohr hin zu wölben und eine der gewölbten bzw. gekrümmten Modulaußenseite gegenüberliegende und zugewandte Rohraußenseite des benachbarten Rohrs zum thermoelektrischen Modul hin gleichsinnig zu wölben. Mit anderen Worten, die Erfindung schlägt somit vor, von der üblichen Kontaktierung zwischen dem jeweiligen thermoelektrischen Modul und dem jeweiligen Rohr in einer Ebene wegzukommen und die Kontaktierung stattdessen in einer gekrümmten oder gewölbten Fläche zu realisieren. Wichtig ist dabei außerdem, dass die Krümmung der jeweiligen Modulaußenseite gleichsinnig zur Krümmung der zugehörigen Rohraußenseite ausgeführt wird. Beispielsweise kann zumindest eine solche Rohraußenseite zum benachbarten thermoelektrischen Modul hin konvex gekrümmt sein und die zugewandte Modulaußenseite des benachbarten thermoelektrischen Moduls kann dann zum Rohr hin konkav gekrümmt sein. Zusätzlich oder alternativ kann zumindest eine solche Rohraußenseite zum benachbarten thermoelektrischen Modul hin konkav gekrümmt sein und die zugewandte Modulaußenseite des benachbarten thermoelektrischen Moduls kann dann zum Rohr hin konvex gekrümmt sein. Bevorzugt sind beide Außenseiten des jeweiligen Rohrs entweder nach außen konvex oder nach außen konkav gekrümmt. Komplementär dazu sind die Außenseiten des jeweiligen thermoelektrischen Moduls vorzugsweise entweder beide nach außen konvex gekrümmt oder nach außen konkav gekrümmt. Grundsätzlich ist jedoch auch eine Ausführungsform denkbar, bei welcher an einem solchen Rohr und/oder bei einem solchen thermoelektrischen Modul die eine Außenseite nach außen konkav gekrümmt ist, während die andere Außenseite nach außen konvex gekrümmt ist. Auch sind Varianten möglich, bei denen nur eine Außenseite des jeweiligen Rohrs und/oder des jeweiligen thermoelektrischen Moduls nach außen konkav oder konvex gekrümmt ist.

Durch die im vorgespannten Zustand entlang gekrümmter Flächen verlaufender, insbesondere kontaktierten, Außenseiten kann die Gefahr einer Beulenbildung aufgrund der Vorspannung reduziert werden. Darüber hinaus führt die erfindungsgemäße Formgebung zu einer vereinfachten Montage, da sich das jeweilige thermoelektrische Modul und das jeweilige Rohr aufgrund der gewölbten Außenseiten relativ zueinander in einer vorbestimmten Relativlage zentrieren.

Erfindungsgemäß sind die Krümmungen der einander zugewandten Außenseiten so gewählt, dass bei fehlender Vorspannkraft, die in einem vorgespannten Zustand des Stapels den Stapel in
der Stapelrichtung zusammendrückt, ein Krümmungsradius der Rohraußenseite und ein Krümmungsradius der Modulaußenseite verschieden sind. Gemäß einer zweckmäßigen Weiterbildung kann dabei der Krümmungsradius der Rohraußenseite bei fehlender Vorspannkraft kleiner sein als der Krümmungsradius der Modulaußenseite. Dies ist bevorzugt dann der Fall, wenn die Rohraußenseite nach außen konvex gekrümmt ist. Bei einer Ausführungsform, bei welcher die Rohraußenseite nach außen konvex gekrümmt ist, kann es vorteilhaft sein, den Krümmungsradius der Rohraußenseite bei fehlender Vorspannkraft größer zu wählen als den der konvexen Modulaußenseite. Durch diese Bauweise mit unterschiedlichen Krümmungsradien kann erreicht werden, dass sich zumindest die Rohraußenseite beim Aufbringen der Vorspannkraft verformt, und zwar zweckmäßig reversibel, also in einen biegeelastischen oder federelastischen Bereich. Hierdurch kann die Vorspannung und somit die Wärmeübertragung zwischen dem jeweiligen thermoelektrischen Modul und dem jeweiligen Rohr verbessert werden.

Gemäß einer besonders vorteilhaften Ausführungsform kann die konvexe oder konkave Rohraußenseite federelastisch ausgestaltet sein und durch eine Vorspannkraft, die in einem vorgespannten Zustand des Wärmetauschers den Stapel in der Stapelrichtung zusammendrückt, federelastisch verformbar ist, und zwar derart, dass die konvexe Rohraußenseite im vorgespannten Zustand einen größeren Krümmungsradius aufweist als in einem entspannten Zustand, in dem die Vorspannkraft fehlt. Mit anderen Worten, die in der jeweiligen Rohraußenseite vorgesehene Krümmung wird beim Verspannen abgeflacht, so dass ihr Krümmungsradius zunimmt. Wichtig ist in diesem Fall, dass auch im vorgespannten Zustand eine konvexe Krümmung der Rohraußenseite erhalten bleibt. Alternativ kann bei konkav gekrümmter Rohraußenseite vorgesehen sein, dass diese im vorgespannten Zustand einen kleineren Krümmungsradius aufweist als in einem entspannten Zustand, in dem die Vorspannkraft fehlt. Mit anderen Worten, die in der jeweiligen Rohraußenseite vorgesehene Krümmung wird beim Verspannen verstärkt, so dass ihr Krümmungsradius abnimmt. Wichtig ist in diesem Fall, dass auch im vorgespannten Zustand eine konkave Krümmung der Rohraußenseite erhalten bleibt.

Gemäß einer vorteilhaften Weiterbildung kann die gekrümmte Modulaußenseite im Vergleich zur gekrümmten Rohraußenseite biegehart sein, also eine höhere Biegesteifigkeit besitzen als die Rohraußenseite. In der Folge verformt sich beim Vorspannen des Stapels die gekrümmte Rohraußenseite stärker als die gekrümmte Modulaußenseite. Beispielsweise kann die Modulaußenseite aus einem biegesteifen Material, bspw. aus einem Keramikmaterial hergestellt sein, während das jeweilige Rohr aus einem biegeweichen Material, bspw. aus Metall hergestellt ist. Insbesondere auf der Kaltseite, also bei den Kühlrohren kann grundsätzlich auch ein Leichtmetall Verwendung finden, während auf der Heißseite, also bei den Heizrohren Stahl- oder Edelstahlrohre bevorzugt sind. Grundsätzlich ist auch eine Ausführungsform denkbar, bei welcher das thermoelektrische Modul im Vergleich zum jeweiligen Rohr biegeweich bzw. elastisch bzw. flexibel ausgestaltet ist. Insbesondere ist dann auch eine Ausführungsform denkbar, bei welcher das jeweilige thermoelektrische Modul im ungespannten Zustand ebene Außenseiten aufweist. Beim Vorspannen kann sich dann das komplette thermoelektrische Modul elastisch verformen, so dass sich seine Außenseiten entsprechend krümmen und sich dabei an die konkav oder konvex gekrümmten Rohraußenseiten anschmiegen, so dass sie im vorgespannten Zustand die erwünschte flächige Kontaktierung entlang gekrümmter Kontaktflächen ermöglichen.

Bei einer anderen Ausführungsform kann vorgesehen sein, dass im vorgespannten Zustand der Krümmungsradius der Rohraußenseite im Wesentlichen gleich groß ist wie der Krümmungsradius der Modulaußenseite. Hierdurch kann eine flächige Kontaktierung zwischen dem jeweiligen thermoelektrischen Modul und dem jeweiligen Rohr realisiert werden, was zu einem besonders homogenen Wärmeübergang führt. Es ist klar, dass dabei kein unmittelbarer Kontakt zwischen der jeweiligen Modulaußenseite und der jeweiligen Rohraußenseite vorliegen muss, vielmehr kann auch eine indirekte Kontaktierung, z.B. über eine Wärmeleitschicht, vorgesehen sein.

Bei einer anderen Ausführungsform können zumindest bei einem solchen thermoelektrischen Modul die Heißseite und die Kaltseite jeweils eine solche gekrümmte Modulaußenseite bilden. Dementsprechend besitzen dann sowohl das benachbarte Kühlrohr als auch das benachbarte Heizrohr jeweils zumindest eine entsprechend gekrümmte Rohraußenseite.

Bei einer anderen vorteilhaften Ausführungsform kann die jeweilige Krümmung bezüglich einer parallel zur Stapelrichtung verlaufenden Längsmittelebene des Stapels spiegelsymmetrisch gestaltet sein. Auf diese Weise vereinfacht sich die Montage, da Verwechslungen vermieden werden können. Gleichzeitig vereinfacht sich dadurch die Herstellung der thermoelektrischen Module sowie der Rohre.

Bei einer bevorzugten Ausführungsform kann vorgesehen sein, dass die jeweilige gekrümmte Außenseite in einer parallel zur Stapelrichtung und senkrecht zu einer Längsrichtung des Stapels verlaufenden Querschnittsebene gekrümmt ist und in einer parallel zur Stapelrichtung und senkrecht zu einer Querrichtung des Stapels verlaufenden Längsschnittsebene geradlinig ist. Hierdurch ergibt sich für die jeweilige Außenseite eine zylindersegmentförmige Krümmung. Bei dieser Bauform ist das jeweilige thermoelektrische Modul in der Stapellängsrichtung relativ zum jeweiligen Rohr in verschiedenen Relativlagen positionierbar.

Bei einer alternativen Ausführungsform kann vorgesehen sein, dass die jeweilige gekrümmte Außenseite sowohl in einer parallel zur Stapelrichtung und senkrecht zu einer Längsrichtung des Stapels verlaufenden Querschnittsebene als auch in einer parallel zur Stapelrichtung und senkrecht zu einer Querrichtung des Stapels verlaufenden Längsschnittsebene gekrümmt ist. Hierdurch ergibt sich bei gleichen Krümmungsradien in der Längsrichtung und in der Querrichtung für die jeweilige Außenseite eine kugelsegmentförmige Krümmung. Sind die Krümmungsradien in der Längsrichtung und der Querrichtung dagegen unterschiedlich, ergibt sich für die jeweilige Außenseite eine ellipsoidsegmentförmige Krümmung. Durch diese Maßnahme wird für das jeweilige thermoelektrische Modul eine einzige Relativlage zum jeweiligen Rohr vorbestimmt, die sich bei der Montage zwangsläufig durch Zentrierung ergibt.

Gemäß einer vorteilhaften Weiterbildung können zwischen einem solchen Heizrohr und einem solchen Kühlrohr mehrere thermoelektrische Module in der Längsrichtung des Stapels hintereinander angeordnet sein, wobei die Modulaußenseiten dieser thermoelektrischen Module jeweils in der Querschnittsebene und in der Längsschnittsebene gekrümmt sind, wobei das jeweilige Rohr mehrere Längsabschnitte aufweist, die in der Stapellängsrichtung hintereinander angeordnet sind, die jeweils einem thermoelektrischen Modul zugeordnet sind und die jeweils in der Querschnittsebene und in der Längsschnittsebene gekrümmt sind. Durch diese Bauweise können zwischen dem jeweiligen Heizrohr und dem jeweiligen Kühlrohr mehrere thermoelektrische Module exakt positioniert werden, wobei sich die jeweilige Relativlage durch die zentrierende Wirkung der kugelsegmentförmigen bzw. ellipsoidsegmentförmigen Krümmungen von selbst einstellt.

Bei einer anderen vorteilhaften Ausführungsform kann vorgesehen sein, dass in der Stapelrichtung zwischen dem jeweiligen Rohr und dem jeweiligen thermoelektrischen Modul eine Wärmeleitschicht angeordnet ist. Eine derartige Wärmeleitschicht, die bspw. mit Hilfe von Wärmeleitpaste oder mit Hilfe einer Grafitfolie gebildet sein kann, kann die Wärmeübertragung zwischen den Außenseiten verbessern. Insbesondere lassen sich mit Hilfe einer derartigen Wärmeleitschicht geringfügige Variationen im Spalt zwischen den einander zugewandten Außenseiten ausgleichen, die aufgrund von Bauteiltoleranzen entstehen können.

Eine erfindungsgemäße Brennkraftmaschine, die vorzugsweise in einem Kraftfahrzeug angeordnet sein kann, umfasst einen Motorblock, der mehrere Brennräume aufweist, eine Abgasanlage zum Abführen von Abgas von den Brennräumen, einen Kühlkreis zum Kühlen des Motorblocks und einen Wärmetauscher der vorstehend beschriebenen Art. Dabei ist wenigstens ein Heizrohr des Wärmetauschers fluidisch in die Abgasanlage eingebunden, so dass das Abgas als Heizfluid dient. Ferner ist wenigstens ein Kühlrohr des Wärmetauschers fluidisch in den Kühlkreis eingebunden, so dass das Kühlmittel des Kühlkreises als Kühlfluid dient. Alternativ kann das jeweilige Kühlrohr des Wärmetauschers in einen zusätzlichen Kühlkreis eingebunden sein, der vom Kühlkreis des Motors unabhängig sein kann. Dabei kann es sich um einen bezüglich des Motor-Kühlkreises separaten Niedertemperatur-Kühlkreis handeln, bei dem die Temperatur des Kühlmittels unterhalb der Kühlmitteltemperatur des Motor-Kühlkreises bleibt, oder um einen bezüglich des Motor-Kühlkreises separaten Hochtemperatur-Kühlkreis handeln, bei dem die Kühlmitteltemperatur im Bereich der Kühlmitteltemperatur des Motorkühlkreises oder darüber liegt.

Der Wärmetauscher kann außerdem mit Mitteln zum Erzeugen der Vorspannung ausgestattet sein. Diese Mittel können bspw. in ein Gehäuse des Wärmetauschers integriert sein. Beispielsweise kann beim Schließen des Gehäuses die Vorspannkraft erzeugt werden. Ebenso ist es möglich, eine spezielle Vorspanneinrichtung vorzusehen, welche den Stapel verspannt. Denkbar ist bspw. eine Ausführungsform, bei der zwei Plattenkörper mit Hilfe von Zugankern relativ zueinander verspannt werden können, wobei zwischen den Platten der Stapel aufgenommen ist.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: eine stark vereinfachte, schaltplanartige Prinzipdarstellung einer Brennkraftmaschine,
- Fig. 2: einen stark vereinfachten Querschnitt durch einen Wärmetauscher,
- Fig. 3: einen stark vereinfachten Querschnitt des Wärmetauschers im Bereich eines thermoelektrischen Moduls in einem entspannten Zustand,
- Fig. 4: einen weiter vereinfachten Querschnitt des Wärmetauschers im Bereich des thermoelektrischen Moduls, jedoch im verspannten Zustand,
- Fig. 5 und 6: jeweils einen stark vereinfachten Längsschnitt durch den Wärmetauscher im Bereich des thermoelektrischen Moduls im verspannten Zustand, bei verschiedenen Ausführungsformen.

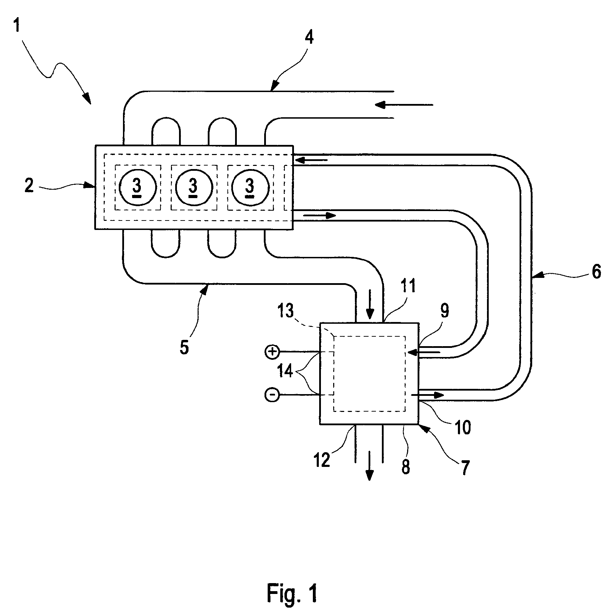

Entsprechend Fig. 1 umfasst eine Brennkraftmaschine 1, die bevorzugt in einem Kraftfahrzeug zum Einsatz kommen kann, einen Motorblock 2, der mehrere Brennräume 3 enthält, eine Frischluftanlage 4 zur Versorgung der Brennräume 3 mit Frischluft und eine Abgasanlage 5 zum Abführen von Abgas von den Brennräumen 3. Desweiteren ist die Brennkraftmaschine 1 mit einem Kühlkreis 6 ausgestattet, mit dessen Hilfe der Motorblock 2 gekühlt werden kann. Dabei ist klar, dass im Kühlkreis 6 außerdem ein hier nicht gezeigter Kühler, ggf. in Verbindung mit einem Gebläse, vorgesehen sein kann, um das im Kühlkreis 6 geführte Kühlmittel entsprechend kühlen zu können. Bei einer anderen Ausführungsform kann außerdem ein weiterer, hier nicht gezeigter Kühlkreis vorgesehen sein, der insbesondere unabhängig vom Primärkühlkreis 6 sein kann. Dieser Sekundärkühlkreis kann dabei optional auf einem anderen Temperaturniveau betrieben werden als der Primärkühlkreis 6.

Die Brennkraftmaschine 1 ist außerdem mit einem Wärmetauscher 7 ausgestattet, dessen Gehäuse 8 einen Kühlmitteleinlass 9, einen Kühlmittelauslass 10, einen Heizmitteleinlass 11 und einen Heizmittelauslass 12 aufweist. Der Wärmetauscher 7 ist über seinen Heizmitteleinlass 11 und seinen Heizmittelauslass 12 in die Abgasanlage 5 fluidisch eingebunden, wobei das Abgas im Wärmetauscher 7 als Heizmittel oder Heizfluid dient. Ferner ist der Wärmetauscher 7 über seinen Kühlmitteleinlass 9 und seinen Kühlmittelauslass 10 in einen Kühlkreis eingebunden, dessen Kühlmittel auch im Wärmetauscher 7 als Kühlmittel bzw. als Kühlfluid dient. Hierbei kann es sich gemäß Fig. 1 um den Primärkühlkreis 6 oder Motorkühlkreis 6 handeln oder aber um den vorstehend erwähnten, hier nicht gezeigten Sekundärkühlkreis. Der Wärmetauscher 7 enthält außerdem zumindest ein thermoelektrisches Modul 13, das im Inneren des Wärmetauschers 7 mit dem Heizfluid und mit dem Kühlfluid wärmeübertragend gekoppelt ist. Am Gehäuse 8 sind elektrische Anschlüsse 14 ausgebildet, die mit dem jeweiligen thermoelektrischen Modul 13 entsprechend elektrisch verbunden sind.

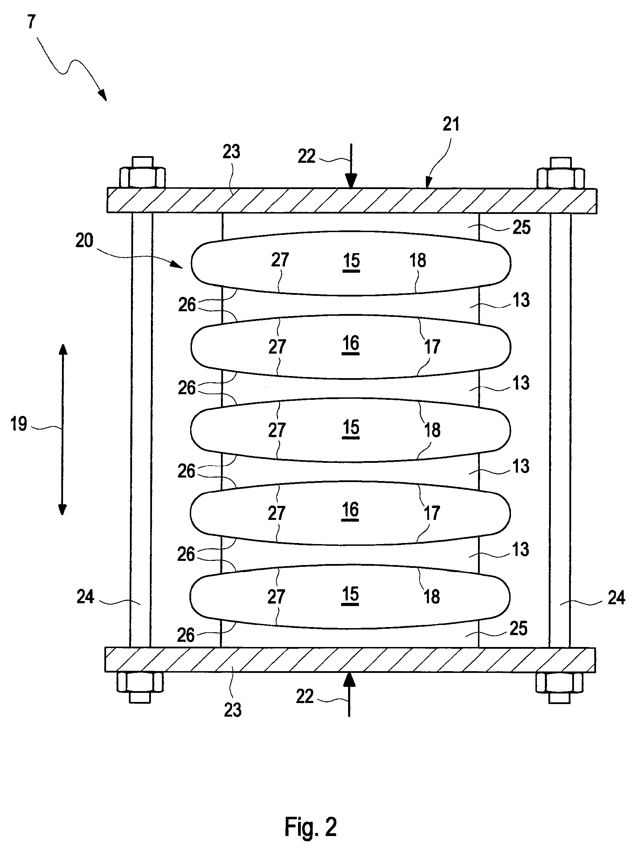

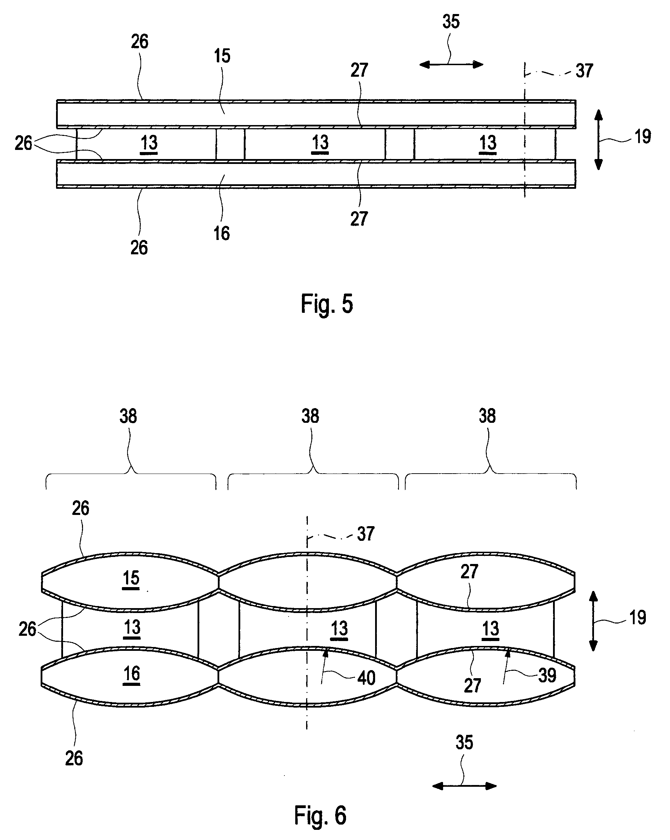

Entsprechend den Fig. 2 bis 6 umfasst der jeweilige Wärmetauscher 7 zumindest ein Kühlrohr 15 zum Führen des Kühlfluids sowie wenigstens ein Heizrohr 16 zum Führen des Heizfluids. Das jeweilige thermoelektrische Modul 13 weist eine Heißseite 17 und eine Kaltseite 18 auf. Das jeweilige Kühlrohr 15 ist an der Kaltseite 18 wenigstens eines solchen thermoelektrischen Moduls 13 angeordnet. Das jeweilige Heizrohr 16 ist an der Heißseite 17 wenigstens eines solchen thermoelektrischen Moduls 13 angeordnet. Das jeweilige thermoelektrische Modul 13, das jeweilige Kühlrohr 15 und das jeweilige Heizrohr 16 sind in einer Stapelrichtung 19 aufeinander gestapelt und bilden einen Stapel 20. Im Beispiel der Fig. 2 sind fünf Rohre vorgesehen, nämlich drei Kühlrohre 15 und zwei Heizrohre 16, zwischen denen in insgesamt vier Ebenen jeweils zumindest ein thermoelektrisches Modul 13 angeordnet ist. Zweckmäßig können gemäß den Fig. 5 und 6 in einer Längsrichtung 35 des Stapels 20 mehrere thermoelektrische Module 13 in der jeweiligen Ebene zwischen je einem Kühlrohr 15 und einem Heizrohr 16 angeordnet sein.

In den Fig. 2 bis 6 ist das Gehäuse 8 des Wärmetauschers 7 nicht dargestellt. Dafür ist in Fig. 2 eine Vorspanneinrichtung 21 gezeigt, mit deren Hilfe eine durch Pfeile angedeutete Vorspannkraft 22 in den Stapel 20 eingeleitet werden kann. Diese Vorspannkraft 22 ist dabei parallel zur Stapelrichtung 19 orientiert. Im Beispiel umfasst die Vorspanneinrichtung 21 zwei Endplatten 23, die über Zuganker 24 in der Stapelrichtung 19 miteinander verspannt sind. Zwischen den Endplatten 23 ist der Stapel 20 aufgenommen, um die Vorspannkraft 22 in den Stapel 20 einzuleiten. Im Beispiel der Fig. 2 sind die Endplatten 23 über Adapterstücke 25 am jeweils außenliegenden Kühlrohr 15 abgestützt.

Bei der hier dargestellten Ausführungsform des Wärmetauschers 7 sind sowohl bei den Kühlrohren 15 als auch bei den Heizrohren 16 Rohraußenseiten 26, die dem jeweils benachbarten thermoelektrischen Modul 13 zugewandt sind, zum jeweiligen thermoelektrischen Modul 13 hin konvex gekrümmt. Ferner sind Modulaußenseiten 27, die den Rohraußenseiten 26 zugewandt sind, zum jeweils benachbarten Rohr 15, 16 hin konkav gekrümmt. Bei einer anderen, hier nicht dargestellten Ausführungsform des Wärmetauschers 7 sind sowohl bei den Kühlrohren 15 als auch bei den Heizrohren 16 die Rohraußenseiten 26, die dem jeweils benachbarten thermoelektrischen Modul 13 zugewandt sind, zum jeweiligen thermoelektrischen Modul 13 hin konkav gekrümmt, während die Modulaußenseiten 27, die den Rohraußenseiten 26 zugewandt sind, zum jeweils benachbarten Rohr 15, 16 hin konvex gekrümmt sind. Ferner ist bei einer weiteren, nicht dargestellten Ausführungsform eine gemischte Bauweise denkbar, die innerhalb desselben Wärmetauschers 7 zumindest ein thermoelektrisches Modul 13 mit konvexen Modulaußenseiten 27 und mindestens ein thermoelektrisches Modul 13 mit konkaven Modulaußenseiten 27 aufweist, wobei die zugehörigen Rohre 15, 16 dann dazu komplementäre Rohraußenseiten 26 aufweisen. Auch ist eine ebenfalls nicht dargestellte Ausführungsform denkbar, bei welcher zumindest ein thermoelektrisches Modul 13 eine konvexe Modulaußenseite 27 und eine konkave Modulaußenseite 27 aufweist, wobei auch hier die Rohre 15, 16 dazu komplementäre Rohraußenseiten 26 besitzen. Theoretisch kann bei einer weiteren, nicht dargestellten Ausführungsform wenigstens eines der thermoelektrischen Module 13 eine ebene Modulaußenseite 27 aufweisen. Die nachfolgenden Ausführungen zur dargestellten Ausführungsform gelten analog auch für die vorstehend erwähnten, jedoch nicht dargestellten Ausführungsformen.

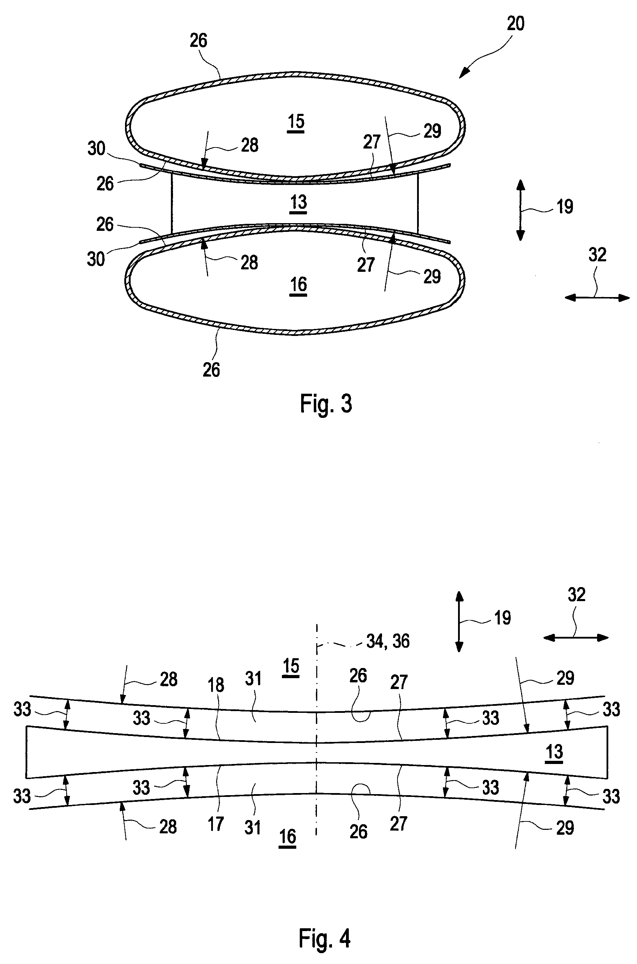

Fig. 3 zeigt einen Ausschnitt des Stapels 20 im Bereich eines einzelnen thermoelektrischen Moduls 13 mit den daran angrenzenden Rohren 15, 16 bei fehlender Vorspannkraft 22. Erkennbar ist in diesem entspannten Zustand ein Rohrkrümmungsradius 28 der jeweiligen Rohraußenseite 26 kleiner als ein Modulkrümmungsradius 29 der Modulaußenseite 27. Hierdurch kommt es beim Stapeln zunächst jeweils zu einer kleinflächigen Kontaktierung zwischen den Rohren 15, 16 und dem thermoelektrischen Modul 13. Außerdem ist in Fig. 3 angedeutet, dass in der Stapelrichtung 19 zwischen dem jeweiligen Rohr 15, 16 und dem jeweiligen thermoelektrischen Modul 13 eine Wärmeleitschicht 30 angeordnet sein kann, so dass keine unmittelbare Kontaktierung zwischen den Rohren 15, 16 und dem thermoelektrischen Modul 13 stattfindet. Vielmehr stehen die Rohraußenseiten 26 nur indirekt über die jeweilige Wärmeleitschicht 30 mit der jeweiligen Modulaußenseite 27 in Kontakt.

Die jeweilige konvexe Rohraußenseite 26 ist zweckmäßig federelastisch ausgestaltet, so dass sie durch die Vorspannkraft 22 federelastisch verformbar ist, derart, dass sich durch die Verformung der Rohrkrümmungsradius 28 vergrößert. Deutlich ist der Rohrkrümmungsradius 28 im vorgespannten Zustand gemäß Fig. 4 größer als im ungespannten Zustand bei fehlender Vorspannkraft. Desweiteren ist die konkave Modulaußenseite 27 im Vergleich zur Rohraußenseite 26 biegehart, so dass sich beim Vorspannen des Stapels 20 die Modulaußenseite 27 nicht oder nur deutlich weniger verformt als die jeweilige Rohraußenseite 26. Insbesondere kann sich dadurch gemäß Fig. 4 im vorgespannten Zustand eine Situation ergeben, in welcher der Rohrkrümmungsradius 28 im Wesentlichen gleich groß ist wie der Mantelkrümmungsradius 29. Hierdurch wird ein in Fig. 4 in der Stapelrichtung 19 stark vergrößert dargestellter Spalt 31 homogenisiert, so dass er über die gesamte in einer Querrichtung 32 des Stapels 20 eine im Wesentlichen konstante Spaltbreite 33 besitzt. Der jeweilige Spalt 31 ist nur dann vorhanden, wenn eine Wärmeleitschicht 30 vorgesehen ist, wobei die Wärmeleitschicht 30 dann den Spalt 31 im Wesentlichen vollständig ausfüllt. Fehlt dagegen eine derartige Wärmeleitschicht 30 reduziert sich die Spaltbreite 33 weitgehend auf den Wert Null, so dass dann die jeweilige Rohraußenseite 26 über die gesamte Breite des thermoelektrischen Moduls 13 unmittelbar an der Modulaußenseite 27 anliegt.

Bei den hier gezeigten Ausführungsformen bilden am jeweiligen thermoelektrischen Modul 13 sowohl die Heißseite 17 als auch die Kaltseite 18 jeweils eine derartige konkave Modulaußenseite 27. Denkbar ist auch eine Ausführungsform, bei der entweder nur die Heißseite 17 oder nur die Kaltseite 18 eine derartige konkave Modulaußenseite 27 bildet, z.B. zum Abschluss des Stapels 20. Sofern jedoch Rohre 15, 16 im Stapel 20 außenliegend angeordnet sind, kann das jeweilige außenliegende Rohr 15, 16, vorzugsweise ein Kühlrohr 15, so ausgestaltet sein, dass es nur an der dem Stapel 20 zugewandten Seite eine gekrümmte Außenseite 27 aufweist, während es an seiner vom Stapel 20 abgewandten Seite eine ebene Außenseite aufweist, die dann an der jeweiligen Endplatte 23 anliegen kann, wodurch auf die einseitig gekrümmten Adapterstücke 25 gemäß Fig. 2 verzichtet werden kann.

In Fig. 4 ist eine Längsmittelebene 34 eingezeichnet, die sich parallel zur Stapelrichtung 19 und parallel zu einer Längsrichtung 35 des Stapels 20 erstreckt, wobei diese Stapellängsrichtung 35 nur in den Fig. 5 und 6 erkennbar ist. Bezüglich dieser Längsmittelebene 34 sind die Krümmungen bzw. die gekrümmten Außenseiten 27, 28 spiegelsymmetrisch gestaltet.

Gemäß den Fig. 5 und 6 können zwischen einem Heizrohr 16 und einem Kühlrohr 15 mehrere thermoelektrische Module 13 in der Stapellängsrichtung 35 hintereinander angeordnet sein. Dabei ist zweckmäßig bei jedem dieser einzelnen thermoelektrischen Module 13 die jeweilige Modulaußenseite 27 in der beschriebenen Weise konkav gekrümmt.

Die Fig. 5 und 6 zeigen Längsschnitte des Stapels 20 im Bereich eines Kühlrohrs 15 und eines Heizrohrs 16 sowie der dazwischen angeordneten thermoelektrischen Module 13. Die Längsschnittsebene ist in Fig. 4 dargestellt und mit 36 bezeichnet. Die Längsschnittsebene 36 erstreckt sich parallel zur Stapelrichtung 19 und parallel zur Stapellängsrichtung 35. Die Längsschnittsebene 36 erstreckt sich somit parallel zur Längsmittelebene 34. Insbesondere können die Längsmittelebene 34 und die Längsschnittsebene 36 zusammenfallen, wie in Fig. 4 dargestellt. In den Fig. 5 und 6 ist außerdem eine Querschnittsebene 37 eingezeichnet, die sich parallel zur Stapel richtung 19 und parallel zur Stapelquerrichtung 32 erstreckt. Die Schnittansichten der Fig. 3 und 4 liegen in einer derartigen Querschnittsebene 37.

Bei der in Fig. 5 gezeigten Ausführungsform sind die gekrümmten Rohraußenseiten 26 und die gekrümmten Modulaußenseiten 27 in der Querschnittsebene 37 gekrümmt und in der Längsschnittsebene 36 geradlinig ausgeführt. Hierdurch erhalten die Außenseiten 26, 27 jeweils eine zylindersegmentförmige Krümmung. Mit anderen Worten, das in den Fig. 3 und 4 wiedergegebene Querschnittsprofil ist in der Stapellängsrichtung 35 im Wesentlichen konstant.

Im Unterschied dazu zeigt Fig. 6 eine Ausführungsform, bei welcher die gekrümmten Rohraußenseiten 26 und die gekrümmten Modulaußenseiten 27 sowohl in der Querschnittsebene 37 als auch in der Längsschnittsebene 36 gekrümmt sind. In dieser Längsschnittsebene 36 besitzt die jeweilige gekrümmte Modulaußenseite 27 dann ebenfalls einen Krümmungsradius 39. Auch besitzt das jeweilige Rohr 15, 16 in der Längsschnittsebene 36 einen Krümmungsradius 40. Dabei können die in der Längsschnittsebene 36 liegenden Krümmungsradien 39, 40 der gekrümmten Außenseiten 26, 27 im vorgespannten Zustand gleich groß sein wie die in der Querschnittsebene 37 liegenden Krümmungsradien 28, 29 der Außenseiten 26, 27. Hierdurch erhalten die gekrümmten Außenseiten 26, 27 zumindest abschnittsweise jeweils eine kugelsegmentförmige Krümmung. Ebenso können bei einer alternativen Ausführungsform die in der Längsschnittsebene 36 liegenden Krümmungsradien 39, 40 der gekrümmten Außenseiten 26, 27 und die in der Querschnittsebene 37 liegenden Krümmungsradien 28, 29 der Außenseiten 26, 27 im vorgespannten Zustand ungleich sein. In diesem Fall erhalten die gekrümmten Außenseiten 26, 27 zumindest abschnittsweise jeweils eine ellipsoidsegmentförmige Krümmung. In beiden Fällen variieren die Querschnittsgeometrien der Fig. 3 und 4 in der Stapellängsrichtung 35.

Fig. 6 zeigt dabei eine spezielle Ausführungsform, bei der das Kühlrohr 15 und das Heizrohr 16 in der Stapellängsrichtung 35 mehrere Längsabschnitte 38 aufweisen, die in Fig. 6 durch geschweifte Klammern angedeutet sind. Innerhalb des jeweiligen Längsabschnitts 38 ist das jeweilige thermoelektrische Modul 13 angeordnet. Diese Längsabschnitte 38 sind dementsprechend in der Stapellängsrichtung 35 hintereinander angeordnet und jeweils einem thermoelektrischen Modul 13 zugeordnet. Innerhalb dieser Längsabschnitte 38 ist die Rohraußenseite 26 in der Querschnittsebene 37 und in der Längsschnittsebene 36 gekrümmt.

## Patentansprüche

1. Wärmetauscher, insbesondere für eine Abgasanlage (5) einer Brennkraftmaschine (1),
- mit wenigstens einem thermoelektrischen Modul (13) zum Wandeln thermischer Energie in elektrische Energie, das eine Heißseite (17) und eine Kaltseite (18) aufweist,
- mit wenigstens einem Kühlrohr (15) zum Führen eines Kühlfluids, das an der Kaltseite (18) wenigstens eines solchen thermoelektrischen Moduls (13) angeordnet ist,
- mit wenigstens einem Heizrohr (16) zum Führen eines Heizfluids, das an der Heißseite (17) wenigstens eines solchen thermoelektrischen Moduls (13) angeordnet ist,
- wobei das wenigstens eine thermoelektrische Modul (13), das wenigstens eine Kühlrohr (15) und das wenigstens eine Heizrohr (16) in einer Stapelrichtung (19) aufeinander gestapelt sind und einen Stapel (20) bilden,
- wobei zumindest eines der Rohre (15, 16) an einer dem jeweiligen thermoelektrischen Modul (13) zugewandten Rohraußenseite (26) gekrümmt ist,
- wobei zumindest das zur gekrümmten Rohraußenseite (26) des jeweiligen Rohrs (15, 16) in der Stapelrichtung (19) benachbarte thermoelektrische Modul (13) an einer dem jeweiligen Rohr (15, 16) zugewandten Modulaußenseite (27) gleichsinnig gekrümmt ist,
**dadurch gekennzeichnet,**
**dass** bei fehlender Vorspannkraft (22), die in einem vorgespannten Zustand des Stapels (20) den Stapel (20) in der Stapelrichtung (19) zusammendrückt, ein Krümmungsradius (28) der Rohraußenseite (26) und ein Krümmungsradius (29) der Modulaußenseite (27) verschieden sind.

2. Wärmetauscher nach Anspruch 1,
**dadurch gekennzeichnet,**
**dass** zumindest eine solche Rohraußenseite (26) zum benachbarten thermoelektrischen Modul (13) hin konvex gekrümmt ist und die zugewandte Modulaußenseite (27) des benachbarten thermoelektrischen Moduls (13) zum Rohr (15, 16) hin konkav gekrümmt ist.

3. Wärmetauscher nach Anspruch 1 oder 2,
**dadurch gekennzeichnet,**
**dass** zumindest eine solche Rohraußenseite (26) zum benachbarten thermoelektrischen Modul (13) hin konkav gekrümmt ist und die zugewandte Modulaußenseite (27) des benachbarten thermoelektrischen Moduls (13) zum Rohr (15, 16) hin konvex gekrümmt ist.

4. Wärmetauscher nach einem der Ansprüche 1 bis 3,
**dadurch gekennzeichnet,**
**dass** der Krümmungsradius (28) der Rohraußenseite (26) kleiner ist als der Krümmungsradius (29) der Modulaußenseite (27).

5. Wärmetauscher nach einem der Ansprüche 1 bis 4,
**dadurch gekennzeichnet,**
**dass** die gekrümmte Rohraußenseite (26) federelastisch ausgestaltet ist und durch eine Vorspannkraft (22), die in einem vorgespannten Zustand des Stapels (20) den Stapel (20) in der Stapelrichtung (19) zusammendrückt, federelastisch verformbar ist, derart, dass die gekrümmte Rohraußenseite (26) im vorgespannten Zustand einen größeren Krümmungsradius (28) aufweist als in einem entspannten Zustand, in dem die Vorspannkraft (22) fehlt.

6. Wärmetauscher nach Anspruch 5,
**dadurch gekennzeichnet,**
**dass** die gekrümmte Modulaußenseite (27) im Vergleich zur gekrümmten Rohraußenseite (26) biegehart ist, so dass sich beim Vorspannen des Stapels (20) die gekrümmte Rohraußenseite (26) stärker verformt als die gekrümmte Modulaußenseite (27).

7. Wärmetauscher nach einem der Ansprüche 3 bis 6,
**dadurch gekennzeichnet,**
**dass** im vorgespannten Zustand der Krümmungsradius (28) der Rohraußenseite (28) im Wesentlichen gleich groß ist wie der Krümmungsradius (29) der Modulaußenseite (27).

8. Wärmetauscher nach einem der Ansprüche 1 bis 7,
**dadurch gekennzeichnet,**
**dass** zumindest bei einem solchen thermoelektrischen Modul (13) die Heißseite (17) und die Kaltseite (18) jeweils eine solche gekrümmte Modulaußenseite (27) bilden.

9. Wärmetauscher nach einem der Ansprüche 1 bis 8,
**dadurch gekennzeichnet,**
**dass** die jeweilige gekrümmte Außenseite (26, 27) bezüglich einer parallel zur Stapelrichtung (19) verlaufenden Längsmittelebene (34) des Stapels (20) spiegelsymmetrisch gestaltet ist.

10. Wärmetauscher nach einem der Ansprüche 1 bis 9,
**dadurch gekennzeichnet,**
**dass** die jeweilige gekrümmte Außenseite (26, 27) in einer parallel zur Stapelrichtung (19) und senkrecht zu einer Längsrichtung (35) des Stapels (20) verlaufenden Querschnittsebene (37) gekrümmt ist und in einer parallel zur Stapelrichtung (19) und senkrecht zu einer Querrichtung (32) des Stapels (20) verlaufenden Längsschnittsebene (36) geradlinig ist.

11. Wärmetauscher nach einem der Ansprüche 1 bis 9,
**dadurch gekennzeichnet,**
**dass** die jeweilige gekrümmte Außenseite (26, 27) sowohl in einer parallel zur Stapelrichtung (19) und senkrecht zu einer Längsrichtung (35) des Stapels (20) verlaufenden Querschnittsebene (37) als auch in einer parallel zur Stapelrichtung (19) und senkrecht zu einer Querrichtung (32) des Stapels (20) verlaufenden Längsschnittsebene (36) gekrümmt ist.

12. Wärmetauscher nach Anspruch 11,
**dadurch gekennzeichnet,**
**dass** zwischen einem solchen Heizrohr (16) und einem solchen Kühlrohr (15) mehrere thermoelektrische Module (13) in der Längsrichtung (35) des Stapels (20) hintereinander angeordnet sind, deren Modulaußenseiten (27) jeweils in der Querschnittsebene (37) und in der Längsschnittsebene (36) gekrümmt sind, wobei das jeweilige Rohr (15, 16) mehrere Längsabschnitte (38) aufweist, die in der Stapellängsrichtung (35) hintereinander angeordnet sind, die jeweils einem thermoelektrischen Modul (13) zugeordnet sind und die jeweils in der Querschnittsebene (37) und in der Längsschnittsebene (36) gekrümmt sind.

13. Wärmetauscher nach einem der Ansprüche 1 bis 12,
**dadurch gekennzeichnet,**
**dass** in der Stapelrichtung (19) zwischen dem jeweiligen Rohr (15, 16) und dem jeweiligen thermoelektrischen Modul (13) eine Wärmeleitschicht (30) angeordnet ist.

14. Brennkraftmaschine, insbesondere für ein Kraftfahrzeug,
- mit einem Motorblock (2), der mehrere Brennräume (3) aufweist,
- mit einer Abgasanlage (5) zum Abführen von Abgas von den Brennräumen (3),
- mit einem Kühlkreis (6) zum Kühlen des Motorblocks (2),
- mit einem Wärmetauscher (7) nach einem der Ansprüche 1 bis 13, dessen jeweiliges Heizrohr (16) fluidisch in die Abgasanlage (5) eingebunden ist und dessen jeweiliges Kühlrohr (15) fluidisch in den Kühlkreis (6) eingebunden ist.

## Claims

1. A heat exchanger, in particular for an exhaust system (5) of an internal combustion engine (1),
- with at least one thermoelectric module (13) for converting thermal energy into electrical energy, which comprises a hot side (17) and a cold side (18),
- with at least one cooling tube (15) for conducting a cooling fluid, which is arranged on the cold side (18) of at least one such thermoelectric module (13),
- with at least one heating tube (16) for conducting a heating fluid, which is arranged on the hot side (17) of at least one such thermoelectric module (13),
- wherein the at least one thermoelectric module (13), the at least one cooling tube (15) and the at least one heating tube (16) are stepped onto one another in a stacking direction (19) and form a stack (20),
- wherein at least one of the tubes (15, 16) is curved on a tube outside (26) facing the respective thermoelectric module (13),
- wherein at least the thermoelectric module (13) which is adjacent to the curved tube outside (26) of the respective tube (15, 16) in the stacking direction (19) is curved in the same direction on a module outside (27) facing the respective tube (15, 16),
**characterized in that** with missing preload force (22) which in a preloaded state of the stack (20) compresses the stack (20) in the stacking direction (19), a curvature radius (28) of the tube outside (26) and a curvature radius (29) of the module outside (27) are distinct.

2. The heat exchanger according to Claim 1, **characterized in that** at least one such tube outside (26) is convexly curved towards the adjacent thermoelectric module (13) and the facing module outside (27) of the adjacent thermoelectric module (13) is concavely curved towards the tube (15, 16).

3. The heat exchanger according to Claim 1 or 2, **characterized in that** at least one such tube outside (26) is concavely curved towards the adjacent thermoelectric module (13) and the facing module outside (27) of the adjacent thermoelectric module (13) is convexly curved towards the tube (15, 16).

4. The heat exchanger according to any one of the Claims 1 to 3, **characterized in that** the curvature radius (28) of the tube outside (26) is smaller than the curvature radius (29) of the module outside (27).

5. The heat exchanger according to any one of the Claims 1 to 4, **characterized in that** the curved tube outside (26) is configured spring-elastically and is spring-elastically deformable through a preload force (22), which in a preloaded state of the stack (20) compresses the stack (20) in the stacking direction (19) in such a manner that the curved tube outside (26) in the preloaded state has a larger curvature radius (28) than in a relaxed state, in which the preload force (22) is missing.

6. The heat exchanger according to Claim 5, **characterized in that** the curved module outside (27) compared with the curved tube outside (26) is rigid, so that during the preloading of the stack (20) the curved tube outside (26) is more strongly deformed than the curved module outside (27).

7. The heat exchanger according to any one of the Claims 3 to 6, **characterized in that** in the preloaded state the curvature radius (28) of the tube outside (28) is substantially identical in size as the curvature radius (29) of the module outside (27).

8. The heat exchanger according to any one of the Claims 1 to 7, **characterized in that** at least with such a thermoelectric module (13) the hot side (17) and the cold side (18) each form such a curved module outside (27).

9. The heat exchanger according to any one of the Claims 1 to 8, **characterized in that** the respective curved outside (26, 27) with respect to a longitudinal centre plane (34) of the stack (20) running parallel to the stacking direction (19) is configured mirror-symmetrically.

10. The heat exchanger according to any one of the Claims 1 to 9, **characterized in that** the respective curved outside (26, 27) is curved in a cross-sectional plane (37) running parallel to the stacking direction (19) and perpendicular to a longitudinal direction (35) of the stack (20) and is linear in a longitudinal section plane (36) running parallel to the stacking direction (19) and perpendicularly to a transverse direction (32) of the stack (20).

11. The heat exchanger according to any one of the Claims 1 to 9, **characterized in that** the respective curved outside (26, 27) is curved both in a cross-sectional plane (37) running parallel to the stacking direction (19) and perpendicularly to a longitudinal direction (35) of the stack (20) and also in a longitudinal section plane (36) running parallel to the stacking direction (19) and perpendicularly to a transverse direction (32) of the stack (20).

12. The heat exchanger according to Claim 11, **characterized in that** between such a heating tube (16) and such a cooling tube (15) multiple thermoelectric modules (13) are arranged one behind the other in the longitudinal direction (35) of the stack (20), the module outsides (27) of which are each curved in the cross-sectional plane (37) and in the longitudinal section plane (36), wherein the receptive tube (15, 16) comprises multiple longitudinal sections (38), which are arranged one behind the other in the stack longitudinal direction (35), each of which are assigned to a thermoelectric module (13) and which are each curved in the cross-sectional plane (37) and in the longitudinal section plane (36).

13. The heat exchanger according to any one of the Claims 1 to 12, **characterized in that** in the stacking direction (19) between the respective tube (15, 16) and the respective thermoelectric module (13) a heat conductive layer (30) is arranged.

14. An internal combustion engine, in particular for a motor vehicle,
- with an engine block (2), which comprises multiple combustion chambers (3),
- with an exhaust system (5) for discharging exhaust gas from the combustion chambers (3),
- with a cooling circuit (6) for cooling the engine block (2),
- with a heat exchanger (7) according to any one of the Claims 1 to 13, the respective heating tube (16) of which is fluidically incorporated in the exhaust system (5) and the respective cooling tube (15) of which is fluidically incorporated in the cooling circuit (6).

## Revendications

1. Echangeur de chaleur, en particulier destiné à un système d'échappement (5) d'un moteur à combustion interne (1),
- comprenant au moins un module thermoélectrique (13) servant à convertir une énergie thermique en une énergie électrique, lequel module présente un côté chaud (17) et un côté froid (18),
- comprenant au moins un tuyau de refroidissement (15) servant à guider un fluide de refroidissement, lequel est disposé au niveau du côté froid (18) au moins d'un module thermoélectrique (13) de ce type,
- comprenant au moins un tuyau de chauffage (16) servant à guider un fluide de chauffage, lequel est disposé au niveau du côté chaud (17) au moins d'un module thermoélectrique (13) de ce type,
- dans lequel l'au moins un module thermoélectrique (13), l'au moins un tuyau de refroidissement (15) et l'au moins un tuyau de chauffage (16) sont empilés les uns sur les autres dans une direction d'empilement (19) et formant une pile (20),
- dans lequel au moins un des tuyaux (15, 16) est courbé au niveau d'un côté extérieur de tuyau (26) tourné vers le module thermoélectrique (13) respectif,
- dans lequel au moins le module thermoélectrique (13) adjacent par rapport au côté extérieur de tuyau (26) courbé du tuyau (15, 16) respectif dans la direction d'empilement (19) est courbé dans le même sens au niveau d'un côté extérieur de module (27) tourné vers le tuyau (15, 16) respectif,
**caractérisé en ce**
**qu'**un rayon de courbure (28) du côté extérieur de tuyau (26) et un rayon de courbure (29) du côté extérieur de module (27) sont différents en l'absence d'une force de précontrainte (22), qui comprime la pile (20) dans la direction d'empilement (19) lorsque la pile (20) est dans un état précontraint.

2. Echangeur de chaleur selon la revendication 1,
**caractérisé en ce**
**qu'**au moins un côté extérieur de tuyau (26) de ce type est courbé de manière convexe en direction du module thermoélectrique (13) adjacent, et en ce que le côté extérieur de module (27) tourné du module thermoélectrique (13) adjacent est courbé de manière concave en direction du tuyau (15, 16).

3. Echangeur de chaleur selon la revendication 1 ou 2,
**caractérisé en ce**
**qu'**au moins un côté extérieur de tuyau (26) de ce type est courbé de manière concave en direction du module thermoélectrique (13) adjacent, et en ce que le côté extérieur de module (27) tourné du module thermoélectrique (13) adjacent est courbé de manière convexe en direction du tuyau (15, 16).

4. Echangeur de chaleur selon l'une quelconque des revendications 1 à 3,
**caractérisé en ce**
**que** le rayon de courbure (28) du côté extérieur de tuyau (26) est plus petit que le rayon de courbure (29) du côté extérieur de module (27).

5. Echangeur de chaleur selon l'une quelconque des revendications 1 à 4,
**caractérisé en ce**
**que** le côté extérieur de tuyau (26) courbé est configuré de manière élastique et peut être déformé de manière élastique par une force de précontrainte (22), qui comprime la pile (20) dans la direction d'empilement (19) lorsque la pile (20) se trouve dans l'état précontraint de telle manière que le côté extérieur de tuyau (26) courbé présente, dans l'état précontraint, un rayon de courbure (28) plus grand que celui dans l'état détendu sans force de précontrainte (22).

6. Echangeur de chaleur selon la revendication 5,
**caractérisé en ce**
**que** le côté extérieur de module (27) courbé est dur en flexion en comparaison avec le côté extérieur de tuyau (26) courbé de sorte que lors de la contrainte de la pile (20), le côté extérieur de tuyau (26) courbé est plus fortement déformé que le côté extérieur de module (27) courbé.

7. Echangeur de chaleur selon l'une quelconque des revendications 3 à 6,
**caractérisé en ce**
**que** dans l'état précontraint, le rayon de courbure (28) du côté extérieur de tuyau (28) est sensiblement aussi grand que le rayon de courbure (29) du côté extérieur de module (27).

8. Echangeur de chaleur selon l'une quelconque des revendications 1 à 7,
**caractérisé en ce**
**qu'**au moins dans le cas d'un module thermoélectrique (13) de ce type, le côté chaud (17) et le côté froid (18) forment respectivement un côté extérieur de module (27) courbé de ce type.

9. Echangeur de chaleur selon l'une quelconque des revendications 1 à 8,
**caractérisé en ce**
**que** le côté extérieur (26, 27) respectif courbé est configuré de manière symétrique en miroir par rapport à un plan central longitudinal (34), s'étendant de manière parallèle par rapport à la direction d'empilement (19), de la pile (20).

10. Echangeur de chaleur selon l'une quelconque des revendications 1 à 9,
**caractérisé en ce**
**que** le côté extérieur (26, 27) respectif courbé est courbé dans un plan de section transversale (37) s'étendant de manière parallèle par rapport à la direction d'empilement (19) et de manière perpendiculaire par rapport à une direction longitudinale (35) de la pile (20) et est rectiligne dans un plan de section longitudinale (36) s'étendant de manière parallèle par rapport à la direction d'empilement (19) et de manière perpendiculaire par rapport à une direction transversale (32) de la pile (20).

11. Echangeur de chaleur selon l'une quelconque des revendications 1 à 9,
**caractérisé en ce**
**que** le côté extérieur (26, 27) respectif courbé est courbé aussi bien dans un plan de section transversale (37) s'étendant de manière parallèle par rapport à la direction d'empilement (19) et de manière perpendiculaire par rapport à une direction longitudinale (35) de la pile (20) que dans un plan de section longitudinale (36) s'étendant de manière parallèle par rapport à la direction d'empilement (19) et de manière perpendiculaire par rapport à une direction transversale (32) de la pile (20).

12. Echangeur de chaleur selon la revendication 11,
**caractérisé en ce**
**que** sont disposés les uns derrière les autres, dans la direction longitudinale (35) de la pile (20) entre un tuyau de chauffage (16) de ce type et un tuyau de refroidissement (15) de ce type, plusieurs modules thermoélectriques (13), dont les côtés extérieurs de module (27) sont courbés respectivement dans le plan de section transversale (37) et dans le plan de section longitudinale (36), le tuyau (15, 16) respectif présentant plusieurs sections longitudinales (38), qui sont disposées les unes derrière les autres dans la direction longitudinale de pile (35), lesquelles sont associées respectivement à un module thermoélectrique (13) et qui sont courbées respectivement dans le plan de coupe transversale (37) et dans le plan de coupe longitudinale (36).

13. Echangeur de chaleur selon l'une quelconque des revendications 1 à 12,
**caractérisé en ce**
**qu'**une couche thermoconductrice (30) est disposée dans la direction d'empilement (19) entre le tuyau (15, 16) respectif et le module thermoélectrique (13) respectif.

14. Moteur à combustion interne, en particulier destiné à un véhicule automobile,
- comprenant un bloc moteur (2), qui présente plusieurs compartiments de combustion (3),
- comprenant un système d'échappement (5) servant à évacuer des gaz d'échappement provenant des chambres de combustion (3),
- comprenant un circuit de refroidissement (6) servant à refroidir le bloc moteur (2),
- comprenant un échangeur de chaleur (7) selon l'une quelconque des revendications 1 à 13, dont le tuyau de chauffage (16) respectif est intégré de manière fluidique dans le système d'échappement (5) et dont le tuyau de refroidissement (15) respectif est intégré de manière fluidique dans le circuit de refroidissement (6).
